# EUROPEAN PATENT APPLICATION

(11) **EP 1 449 902 A1**
(43) Date of publication of application: **25.08.2004**
(21) Application number: 02803105.2
(22) Date of filing: 11.11.2002
(51) Int. Cl.: C09K 3/00, H01L 31/04, H01M 14/00, C09K 11/06

(54) **LIGHT ABSORPTIVE COMPOSITION**

(30) Priority: 13.11.2001 JP 2001347286
(71) Applicant: Kabushiki Kaisha Hayashibara Seibutsu Kagaku Kenkyujo, Okayama-shi, Okayama 700-0907 (JP)
(72) Inventor: OHTAKA, Hideo c/o K. K. Hayashibara, Okayama-shi, Okayama 700-0907 (JP); MITEKURA, Hirofumi c/o K. K. Hayashibara, Okayama-shi, Okayama 700-0907 (JP); YANO, Kentaro c/o K. K. Hayashibara, Okayama-shi, Okayama 700-0907 (JP); MATSUI, Fumio c/o K. K. Hayashibara, Okayama-shi, Okayama 700-0907 (JP)
(74) Representative: Jenkins, Peter David
(86) International application number: PCT/JP2002/011731
(87) International publication number: WO 2003/042320

(57) **Abstract**

The object of the present invention is to provide a light absorptive composition which exerts an improved photoelectric conversion efficiency in photoelectric conversion elements such as solar cells. The present invention attains the above object by providing a light absorptive composition, which comprises a first organic compound that absorbs light with a wavelength ranging from the ultraviolet region to the visible region to emit light with a longer wavelength than that of the absorbed light, and a second organic compound that absorbs the light emitted from the first organic compound; a semiconductor electrode which has been sensitized with the light absorptive composition; a photoelectric conversion element comprising the light absorptive composition; and a solar cell comprising the light absorptive composition.

## Description

### Technical Field

The present invention relates to a light absorptive material, more particularly, to a light absorptive composition useful in photoelectric conversion elements such solar cells.

### Background Art

In these days flooded with ecology-valued culture, solar power generation has been being highlighted as a means for generating clean energy without spoiling environment, replaceable with firepower and nuclear power generations. It has long been well known the theory of solar power generation that semiconductors generate electromotive force when irradiated with light, and there have been devised single crystalline silicon solar cells, polycrystalline silicon solar cells, amorphous solar cells, compound semiconductor solar cells, inorganic solar cells, organic solar cells, and photoelectrochemical solar cells (wet solar cells). As it is well known, some of the above solar cells have been realized, and they have been promptly, widely used as light weight and long shelf-life power sources, i.e., portable equipments and easy-power-generators for home use in general, in spite of their relatively low generation power.

The urgent necessity residing in exploring solar cells is the reduction of generation cost sufficiently replaceable with the generation means now used such as a firepower generation, particularly, the cost reduction and the enlargement of areas of solar modules. Among the above-identified solar cells, the photoelectrochemical solar cells have been recognized as ones with advantageous potential because, in their preparation, semiconductors are easily made to form junction if only soaked in electrolytic solutions, and they are expected to have a relatively high photoelectric conversion efficiency even when prepared with polycrystalline materials.

Most of the conventional photoelectrochemical solar cells have been constructed in such a manner that either of a pair of electrodes is allowed to emit light after absorbing light. Particularly, it has been said that those comprising a dioxide electrode have a distinctively high energy conversion efficiency. As regards these electrodes and photosensitizers for composing photoelectrochemical solar cells, some types of light absorptive organic compounds, especially, bipyridyl ruthenium complexes were proposed, for example, in "*Solar Energy*", Vol. 23, No. 4, pp. 11-18 (1997), editedbyYoshinoriArakawaetal., and"*Chemistry on Surface*", Vol. 21, No. 5, pp. 288-293 (2000), edited by Takayuki Kitamura et al.

Since the above light absorptive organic compounds, however, have as a demerit a relatively narrower light absorption range compared with that utilized by solar cells, they could not efficiently use solar light through over the solar spectrum when used alone. For this reason, even if a plurality of such organic compounds are used in combination, the overall light absorptive property of the final composition as a whole would be limited by the one with the lowest light absorptive property among the organic compounds used. Thus, it has been difficult to improve the photoelectric conversion efficiency of photoelectrochemical solar cells.

Under these circumstances, the object of the present invention is to provide a light absorptive composition which exerts an improved light conversion efficiency in photoelectric conversion elements such solar cells.

### Disclosure of Invention

The present inventors eagerly studied and screened combinations of various organic compounds including luminous organic compounds and found that it can attain a significantly high photoelectric conversion efficiency, which has not been easily attained by a single use of a light absorptive organic compound that absorbs the light emitted from another light absorptive organic compound that absorbs light in the ultraviolet region and the visible region and emits light with a longer wavelength than that of the absorbed light.

The present invention attains the above object by providing a light absorptive composition comprising a first organic compound which absorbs light in the ultraviolet region and the visible region and emits light with a longer wavelength than that of the absorbed light, and a second organic compound which absorbs the light emitted from the first organic compound.

The present invention also attains the above object by providing a semiconductive electrode sensitized with the above light absorptive composition.

The present invention attains the above object by providing a photoelectric conversion element comprising the above light absorptive composition.

The present invention attains the above object by providing a solar cell comprising the above light absorptive composition.

### Brief Description of Drawings

FIG. 1 is a brief drawing of an example of the photoelectric conversion element according to the present invention.
FIG. 2 is a brief drawing of the absorption region and the luminous region for the compounds used as a first- and a second-organic-compounds in the present invention.

Explanation of Symbols:
- 1 :: Semiconductor
- 2a, 2b :: Transparent electrode
- 3 :: Semiconductor film
- 4 :: Electrode
- 5 :: Redox electrolytic solution
- 6 :: External load

### Best Mode For Carrying Out the Invention

Now explaining the preferred embodiments according to the present invention, this invention, as mentioned above, relates to a light absorptive composition comprising a first organic compound which absorbs light in the ultraviolet region and the visible region and emits light with a longer wavelength than that of the absorbed light, and a second organic compound which absorbs the light emitted from the first organic compound.

The first organic compound, as a constituent of the light absorptive composition of the present invention, is generally selected from those which absorb light in the ultraviolet region and the visible region with a wavelength of shorter than 800 nm, and emit fluorescence or phosphorescence in the visible region or the infrared region with a wavelength of longer than 400 nm. The first organic compound should not be restricted to a homogeneous compound and may be optionally an appropriate combination of a plurality of luminous organic compounds which emit light in different luminous regions depending on the desired use of the light absorptive composition and on the light absorptive property of the second organic compound used in combination. The second organic compound can be selected from among light absorptive organic compounds which substantially absorb the light emitted from the first organic compound, and may be optionally an appropriate combination of a plurality of light absorptive organic compounds in order to modulate the sensitivity of the first organic compound to the desired level.

Concrete examples of the first organic compound include the following light absorptive organic compounds: Oxazole compounds and cumarin compounds, which absorb light in the ultraviolet region or the blue region and emit fluorescence or phosphorescence in the visible region with a wavelength of around 400 to 500 nm; perylene compounds which emit fluorescence or phosphorescence in the green region with a wavelength of around 500 to 600 nm; and organic metal complexes which emit fluorescence or phosphorescence in the red region with a wavelength longer than 600 nm, which all, as already mentioned, can be optionally used in an appropriate combination. Varying depending on the use of the light absorptive composition, when used in photosensitizers for photoelectric conversion elements such as photoelectrochemical solar cells, the following are preferably used as the first organic compound: Metal elements selected from those belonging to the 9 to 13 groups in the periodic law table such as iridium, zinc, and aluminum, which are disclosed in *"The Journal* of *the American Chemical Society"* by L. R. Melby et al., Vol. 86, No. 23, pp. 5,117-5,125 (1964), *"Breten* of *the Chemical Society of Japan*", by Masahiro UEKAWA et al., Vol. 71, No.9, pp. 2,253-2,258 (1998), *"The Journal of the American Chemical Society*" bySergeyLamanskyetal. , Vol. 123, No. 18, pp. 4,304-4,312 (2001), and "Inorganic Chemistry" by Selgay Ramansky, Vol. 40, pp. 1,704-1,711 (2001); and organic complexes having a rare-earth element as a central atom in the lanthanum series such as europium. Among these, most preferably used are enedione-diolate complexes, which comprise europium as a central atom and three or four molecules of an enedione compound configured to the europium.

As the second organic compound, light absorptive organic compounds, which are commonly used as photosensitizers in the field of photoelectrochemical solar cells, can be used alone or in an appropriate combination. Concrete examples of such are polymethine dyes such as an azulenium, oxanol, cyanine, squallilium, styryl, thiopyrylium, pyrylium, phenanthrene, phthalocyanine, and melocyanine dyes; and others including acridine dyes, azaannulene dyes, azo dyes, anthraquinone dyes, indigo dyes, indanthrene dyes, oxadine dyes, xanthene dyes, cumarin dyes, dioxazine dyes, thiazine dyes, thioindigo dyes, tetraporphyrin dyes, triphenylmethane dyes, triphenothiazine dyes, naphthoquinone dyes, phthalocyanine dyes, benzoquinone dyes, benzopyrane dyes, benzofuranone dyes, porphyrin dyes, Rhodamine dyes, and pyrromethene dyes, which all can be used in an appropriate combination. Among these, most preferably used are cumarin dyes and polymethine dyes such as cyanine dyes, particularly, the cumarin dyes and the polymethine dyes, disclosed in Japanese Patent Application No. 2001-185666, titled "Ethylene compounds" applied for by the same applicant as the present invention, where hydrogen atoms, linked to C-1 of the ethylene skeleton of the respective dyes, are respectively replaced with a hydrocarbon group and an atomic group capable of absorbing the visible light; and either of the hydrogen atoms, linked to C-2 of the ethylene skeleton, contains an atom having an unshared electron pair.

In the light absorptive composition comprising both the above-identified organic compounds in combination, it is usually prepared by mixing, at least 0.1 mole, preferably, at least 0.5 mole of the first organic compound with one mole of the second organic compound, though the ratio varies depending on the emission quantum efficiency of the first organic compound and the molecular absorption coefficient(may be abbreviated as "ε" hereinafter) of the second organic compound. It goes without saying that the first- and the second-organic-compounds must not necessarily be a homogeneous compound as mentioned above, and either or both of which can be constructed by appropriately combining a plurality of organic compounds to meet the final use of the light absorptive composition of the present invention. Further, the light absorptive composition of the present invention is never restricted to specific organic compounds having a specific light absorption region and/or a luminous region, and may include those which comprise one or more other additional light absorptive organic compounds capable of absorbing light in the ultraviolet, visible and/or infrared regions can be added to the first- and the second-organic-compounds for imparting the desired light property as a whole.

Explaining the use of the light absorptive composition of the present invention, it is quite advantageously used in the fields where light absorptive materials are required because the composition can be constructed to have a specific light absorbability in the desired wavelength region ranging from the ultraviolet region to the visible region. In particular, the light absorptive composition, having a relatively high affinity to semiconductors, is quite advantageously used in solar cells, specifically, in materials for sensitizing semiconductor electrodes which are applicable to photoelectric conversion elements such as photoelectrochemical solar cells.

As regard the use of the light absorptive composition of the present invention, semiconductor electrodes which have been sensitizedwith the composition, and photoelectric conversion elements and solar cells, prepared with the above semiconductor electrodes, are respectively explained below: The semiconductor electrodes according to the present invention can be obtained by sensitizing semiconductor electrodes, commonly used in photoelectrochemical solar cells, etc., with the light absorptive composition of the present invention. Such semiconductor electrodes can be obtained through the steps of forming a semiconductor layer on a part or the whole surface of an electroconductivetransparent electrodeformedin a plate,column, prism, or net form; and depositing the light absorptive composition of the present invention on the above semiconductor layer. Any electroconductive transparent electrodes can be used in the present invention without being specifically restricted as long as they have the desired conductivity. Examples of such are those prepared by, to form a substantially transparent thin layer, coating tin oxides (NESA) incorporated with a small amount of fluorine or antimony, indium oxides (ITO) incorporated with a small amount of tin, or zinc oxides over substrates such as glasses, ceramics, and plastics, which are substantially transparent through over the desired wavelength region ranging from the ultraviolet region to the infrared region. Among which, those with thin layers formed by coating substrates with tin oxides are most preferably used.

The above-identified semiconductor layers can be usually prepared by conventional methods comprising the steps of depositing semiconductive nano-sized particles having a porous structure and a mean particle size of 5 to 500 nm on electroconductive transparent electrodes to form layers with a thickness of 0.1 to 100 pm, preferably, 1 to 50 pm; and sintering the resultants. Examples of semiconductors usable for constructing the semiconductor layers are compound semiconductors in general which are commonly used in this art, particularly, metal oxides such as cerium, titanium, zirconium, vanadium, niobium, tungsten, iron, nickel, indium, zinc, and bismuth oxides; composite metal oxides such as strontium titanate, barium titanate, potassium niobate, and sodium tantalate; metal-halogen compounds such as silver iodide, copper iodide, and copper bromide; metal sulfides such as zinc sulfide, titanium sulfide, indium sulfide, bismuth sulfide, cadmium sulfide, zirconium sulfide, tantalum sulfide, silver sulfide, copper sulfide, zinc sulfide, tungsten sulfide, and molybdenum sulfide; and chalcogenide compounds such as cadmium selenide, zirconium selenide, zinc selenide, titanium selenide, indium selenide, tungsten selenide, molybdenum sulfide, bismuth selenide, cadmium selenide, bismuth selenide, cadmium tellurate, tungsten tellurate, molybdenum tellurate, zinc tellurate, and bismuth tellurate, which can be used in an appropriate combination. Inparticular, compound semiconductors, comprising semiconductor particle groups having a plurality of peaks of particle size distribution, disclosed in Japanese Patent Kokai No. 2001-357899 (Japanese Patent Application No. 2000-111331), titled "Semiconductor layer, solar cell using the same, and their production methods and uses", applied for by the same applicant as the present invention, can be advantageously used in the semiconductor electrodes according to the present invention. The above-identified semiconductors are mere examples usable in the present invention, and the semiconductors usable in the present invention are not limited thereto. In practicing the present invention, preferably used are those selected from among p- and n-types of semiconductors as long as they do not depart from the scope of the object of the present invention.

The semiconductor electrodes thus obtained can be sensitized by dissolving the light absorptive composition of the present invention in an appropriate solvent to give a concentration ranging from 0.01 mM to a saturated concentration, preferably, from 0.1 mM to 0.5 mM; soaking the electrodes in the solvent; and allowing the electrodes to stand at ambient temperature or over for at least one minute, preferably, 12 to 48 hours under such soaking conditions. Any solvents can be used as long as they dissolve the light absorptive composition of the present invention; alcohols such as methanol, ethanol, 2,2,2-trifluoroethanol, 1-propanol, 2-propanol, 2-propanol, 1-butanol, 2-butanol, isobutyl alcohol, isopentyl alcohol, and cyclohexanol; hydrocarbons such as benzene, toluene, and xylene; nitriles such as acetonitrile, propionitrile, and succinonitrile; and ethers such as diethyl ether, diisopropyl ether, tetrahydrofuran, tetrahydropyran, and 1,4-dioxane, which can be optionally used in an appropriate combination. Among these solvents, alcohols such as methanol and ethanol; nitriles such as acetonitrile; and mixtures thereof are preferably used due to their satisfactory dissolvability.

The semiconductor electrodes,sensitized with the light absorptive composition of the present invention, are quite useful as such for use in photoelectric conversion elements. The present invention also provides a photoelectric conversion element prepared with the light absorptive composition, which comprises a semiconductor electrode sensitized with the light absorptive composition, a counter electrode, and a Redox electrolytic solution to be contacted with these electrodes.

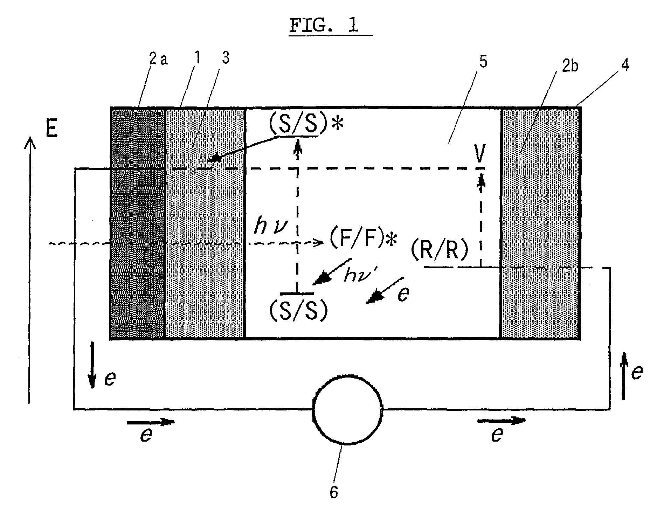

FIG. 1 is a brief figure of an example of the photoelectric conversion element according to the present invention, where the numeral 1 represents a semiconductor electrode. As already mentioned, a semiconductor such as a compound semiconductor is adsorbed on a part or the whole surface of a transparent electrode 2a to form a layer, followed by adsorbing the light absorptive composition unto the formed semiconductor layer 3 for its sensitization.

The numeral 4 is a counter electrode usually prepared by, similarly as in the semiconductor electrode 1, coating a metal such as iron, ruthenium, cobalt, rhodium, nickel, platinum, copper, silver, gold, zinc, aluminum, or tin; or carbon or a semiconductor, as used in the preparation of the semiconductor electrode 1, on a part or the whole surface of the electroconductive transparent electrode 2b by using conventional methods such as vacuum deposition, chemical deposition, spattering, atomic layer epitaxy (ALE), applying, and soaking.

The numeral 5 is a Redox electrolytic solution, prepared by incorporating into a solvent a mixture, as a Redox electrolyte, of iodide and an iodide compound(s) such as imidazolium iodide derivatives, lithium iodide, potassium iodide, and tetraalkylammonium iodide, which give a Redox system such as those of iodide, iron, zinc, chromium, vanadium, sulfide, or anthraquinone; or, as a Redox electrolyte, a mixture of iodine and an iodine compound such as imidazolium bromide derivatives, lithium bromide, potassium bromide, or tetraalkylammonium bromide.

Any solvents can be used as the solvents for the Redox electrolytic solution 5 without being specifically restricted, as long as they are easily handleable, stable, and capable of substantially dissolving the above-exemplified Redox electrolytes. Concrete examples of such solvents are nitriles such as acetonitrile, methoxyacetonitrile, propionitrile, methoxypropionitrile, and succinonitrile; esters such as ethylene carbonate and propylene carbonate; amides such as N,N-dimethylformamide, N,N-dimethylacetamide, and hexamethylphosphoric triamide; ethers such as tetrahydrofuran, tetrahydropyran, 1,4-dioxane, and dicyclohexyl-18-crown-6; amines such as pyridine; nitro compounds such as nitromethane; and sulfur-atom-containing compounds, which can be optionally used in an appropriate combination. The Redox electrolytic solutions usable in the photoelectric conversion element according to the present invention are never restricted to those in a solution form, and they can be used after the addition of semi-solid electrolytes which have been previously gelled with gelatinizers.

A spacer for preventing a semiconductor electrode 1 from physical contact with a counter electrode 4 can be optionally installed in the photoelectric conversion element according to the present invention. Examples of the materials for such a spacer are non-electroconductive materials including plastics such as polyesters, polycarbonates, polysulfonates, poly(methyl polyacrylate), polypropylenes, and polystylenes; glasses such as quartz glasses, soda-lime glasses, aluminosilicate glasses, borosilicate glasses, barium silicate glasses, and barium borosilicate glasses; quartz; and ceramics such as earthen wares, which all can be formed into films or sheets, having a thickness of one micrometer, preferably, 10 to 50 µm, in a sole use or in an appropriate combination. The aforesaid spacer can be omitted when cells for housing the photoelectric conversion element has a structure of preventing physical contact of the above two electrodes.

Now explaining the operation of the photoelectric conversion element of the present invention, in the photoelectric conversion element in FIG. 1, a first organic compound F/F on the semiconductor electrode 1 is excited to an excited organic compound F/F* having a higher energy level E after receiving and absorbing light (hv). The excited first organic compound F/F* emits both fluorescence having a longer wavelength than that of the received light and light (hv') such as phosphorescence. A second organic compounds S/S absorbs the light (hv' ) and changes into an excited second organic compound S/S*. The excited electrons (e) in the excited second organic compound S/S* are injected into the conduction band level of a semiconductor layer 3 and transferred to a transparent electrode 2a as a back-contact through the semiconductor electrode 1. While, the remaining second organic compound S/S, which has lost electron (e), is reduced after receiving electron (e) from, for example, a Redox ion R/R such as I⁻ ion in the Redox electrolytic solution 5. On the counter electrode 4, a counter ion among the Redox ion such as I³⁻ ion is then reduced again to form iodine ion. Based on the above electron (e) flow, an electromotive force V is generated between the transparent electrode 2a and the counter electrode 4, followed by energization of an external load 6 with current.

The light absorptive composition of the present invention was made based on the finding that the light absorbability of a light absorptive organic compound can be constructed to be improved to an extent as if the ability has been expanded up to a wavelength region that is not intrinsically absorbed by the light absorptive organic compound when a luminous organic compound is excited by light with a wavelength ranging from the ultraviolet region to the visible region, and the light emitted from the excited luminous organic compound is allowed to be absorbed by the light absorptive organic compound. The photoelectric conversion element of the present invention, which comprises the above light absorptive composition as a photosensitizer, easily and effectively uses even light with a wavelength in the ultraviolet region and in the near ultraviolet region, which could not have been effectively used when the light absorptive compound is used alone. As a result, the photoelectric conversion efficiency of the photoelectric conversion element will be significantly improved.

In addition to the use of the light absorptive composition of the present invention as a photosensitizer in the above mentioned photoelectric conversion element, it has various uses as a material for exposing polymerizable compositions to the visible light, regulating the chromaticity of optical filters, and for dying clothes. Since the light absorptive composition of the present invention absorbs light in the light absorption range nearness to the light with a wavelength of 400 to 550 nm emitted from common lasers including gas lasers such as argon ion lasers and krypton ion lasers; semiconductor lasers such as CdS lasers; solid-state lasers such as distributed feed back lasers or distributed Bragg reflection Cd-YAG lasers, it can be advantageously used as a sensitizer in light polymerizable compositions using the above-identified lasers as exposure light sources; and it can be also used in the fields of information recordings such as facsimiles, copying machines, and printers; printings such as flexographies and gravure printings; and printing circuits such as photoresists.

The light absorptive composition of the present invention, which comprises the first- and the second-organic-compounds and optionally one or more other light absorptive materials for absorbing light in the ultraviolet, visible, or infrared region, can be used in clothes in general and others, for example, building/bedding/decorating products such as a drape, lace, casement, print, casement cloth, roll screen, shutter, shop curtain, blanket, thick bedquilt including comforter, peripheral material for the thick bedquilt, cover for the thick bedquilt, cotton for the thick bedquilt, bed sheet, cushion, pillow, pillow cover, cushion, mat, carpet, sleeping bag, tent, interior finish for vehicles including cars, and window glasses including car window glass; sanitary and health goods such as a paper diaper, diaper cover, eyeglasses, monocle, and lorgnette; internal base sheets, linings, and materials for shoes; wrappers; materials for umbrellas; parasols; stuffed toys; lighting devices; filters, panels and screens for information displaying devices such as televisions and personal computers whichusecathode-raytubes, liquidcrystal displays, electrolytic luminous displays, and plasma displays; sunglasses; sunroofs; sun visors; pet bottles; storages; vinyl houses; lawns; optical fibers; prepaid cards; and peeping windows in electric ovens and other type ovens. When used as wrapping materials, injection materials, and vessels for the above products, the light absorptive composition of the present invention prevents living bodies and the above products from being affected by troubles and discomforts induced by environmental light such as natural and artificial light or even lower the level of such troubles and discomforts, and furthermore it can advantageously regulate the color, tint, and appearance, and control the light reflected by or passed through the products to the desired color balance.

The preferred embodiments according to the present invention are the following:

### Example 1

### Light absorptive composition

A light absorptive composition, which exerts photosensitizing ability when it receives the light ranging from the ultraviolet region to the red-orange region, was obtained by mixing to homogeneity an enedione-diolate complex, as a first organic compound, represented by Chemical Formula 1 and having an absorption maximum wavelength of 346 nm and a fluorescent maximum wavelength of 613 nm; and a polymethine dye, as a second organic compound, represented by Chemical Formula 2 and having an absorption maximum wavelength of 598 nm and ε of 1.5 x 10⁵, in a molar ratio of 1:1.

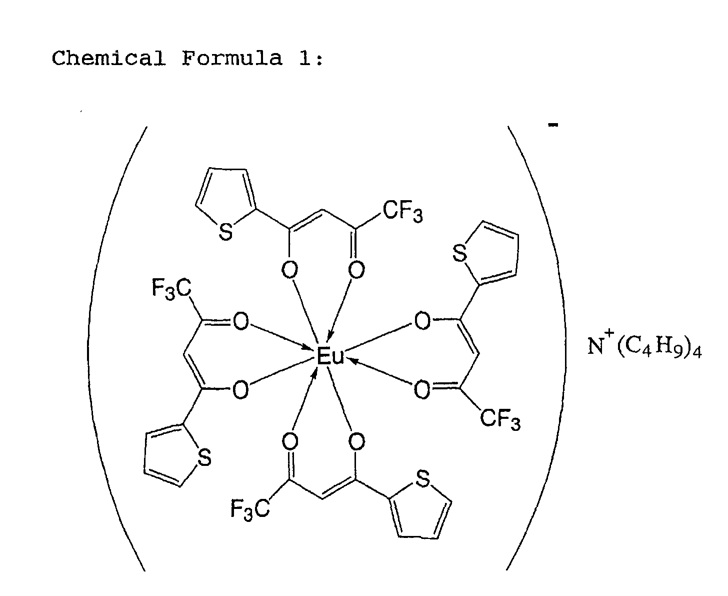

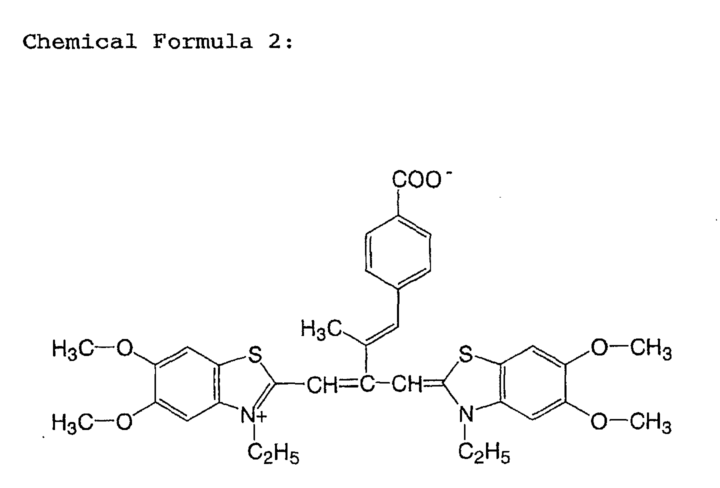

The light absorptive composition of this example can be advantageously used as a material for sensitizing semiconductor electrodes in photoelectric conversion elements such as solar cells, and for sensitizing polymerizable compounds in photochemical polymerization.

### Example 2

### Light absorptive composition

A light absorptive composition, which exerts photosensitizing ability when it receives the light ranging from the ultraviolet region to the blue region, was obtained by mixing to homogeneity an oxazole complex, as a first organic compound, represented by Chemical Formula 3 and having an absorption maximum wavelength of 380 nm and a fluorescent maximum wavelength of 430 nm; and a cumarin dye, as a second organic compound, represented by Chemical Formula 4 and having an absorption maximum wavelength of 443 nm and ε of 3.9 x 10⁴, in a molar ratio of 2:1.

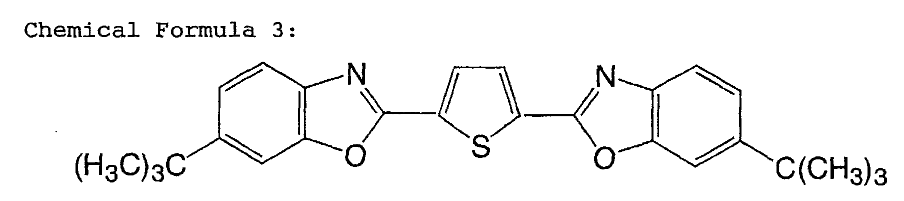

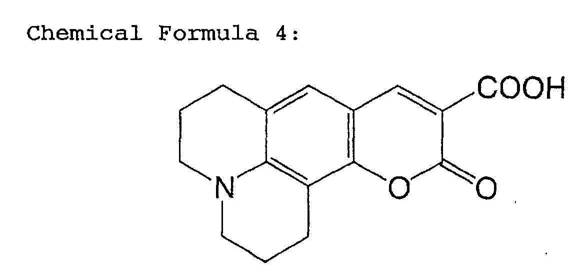

The light absorptive composition of this example can be advantageously used as a material for sensitizing semiconductor electrodes in photoelectric conversion elements such as solar cells, and for sensitizing polymerizable compounds in photochemical polymerization.

### Example 3

### Light absorptive composition

A light absorptive composition, which exerts photosensitizing ability when it receives the light ranging from the ultraviolet region to the green region, was obtained by mixing to homogeneity an oxazole complex, as a first organic compound, represented by Chemical Formula 5 and having an absorption maximum wavelength of 387 nm, ε of 6.6 x 10³, and a fluorescent maximum wavelength of 514 nm; and a polymethine dye, as a second organic compound, represented by Chemical Formula 6 and having an absorption maximum wavelength of 525 nm and ε of 1.1 x 10⁵, in a molar ratio of 1:1.

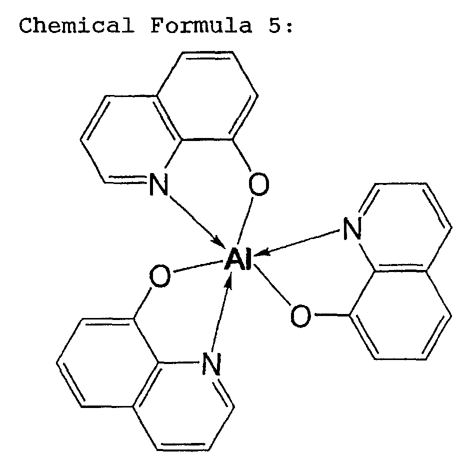

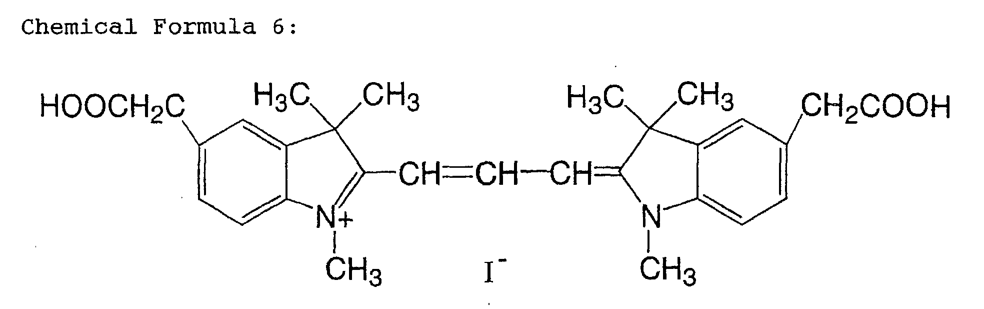

The light absorptive composition of this example can be advantageously used as a material for sensitizing semiconductor electrodes in photoelectric conversion elements such as solar cells, and for sensitizing polymerizable compounds in photochemical polymerization.

### Example 4

### Light absorptive composition

A light absorptive composition, which exerts photosensitizing ability when it receives the light ranging from the ultraviolet region to the red region, was obtained by mixing to homogeneity an oxazole complex, as a first organic compound, represented by Chemical Formula 7 and having an absorption maximum wavelength of 340 nm, ε of 1.3 x 10⁴, and a fluorescent maximum wavelength of 612 nm; and a polymethine dye, as a second organic compound, represented by Chemical Formula 8 and having an absorption maximum wavelength of 629 nm and ε of 2.6 x 10⁵, in a molar ratio of 2:1.

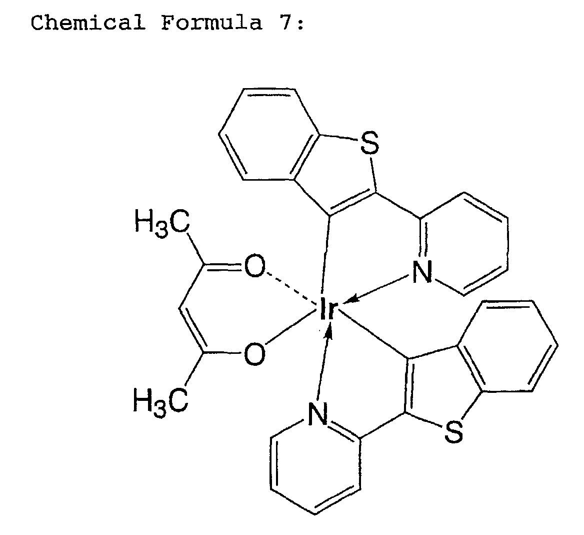

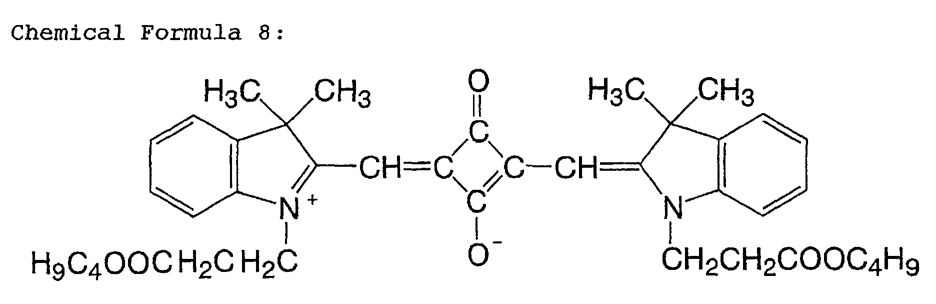

The light absorptive composition of this example can be advantageously used as a material for sensitizing semiconductor electrodes in photoelectric conversion elements such as solar cells, and for sensitizing polymerizable compounds in photochemical polymerization.

### Example 5

### Light absorptive composition

A light absorptive composition, which exerts a sensitizing ability when it receives the light ranging from the ultraviolet region to the red region, was prepared by mixing to homogeneity four types of light absorptive compositions, obtained by the methods in Examples 1 to 4, in a weight ratio of 1:3:2:1.

The composition thus obtained can be advantageously used, for example, as a material for sensitizing semiconductor electrodes in photoelectric conversion elements such as solar cells, and for sensitizing polymerizable compounds in photochemical polymerization.

### Example 6

### Semiconductor electrode

A semiconductor electrode was obtained by mixing nano-sized particles of titanium oxide having an average particle size of 23 nm and 12 nm, respectively, in a weight ratio of 4: 1, dispersing the mixture in a 20% (w/w) aqueous polyethylene glycol solution, coating the suspension over either surface of a common electroconductive glass substrate, drying the substrate, and sintering the dried substrate at 450°C for 30 min.

While, a light absorptive composition, obtained by the method in Example 1, was dissolved in ethanol to give a concentration of 1 x 10⁻⁴ M as a total concentration of the organic compounds used. The above sintered semiconductor electrode was soaked in the above ethanol solution, allowed to stand at ambient temperature for 12 hours, taken out from the solution, and dried to obtain a semiconductor electrode, sensitized with the light absorptive composition of the present invention.

The product can be advantageously used, for example, as a semiconductor electrode for composing photoelectric conversion elements in photochemical solar cells.

### Example 7

### Photoelectric conversion element

A semiconductor electrode, obtained by the method in Example 6, and a counter electrode, obtained by spattering platinum over an electroconductive glass substrate having a tin oxide layer containing a slight amount of fluorine to form a layer having 100 nm in thickness, were installed in an inner part of a cell, followed by placing a spacer of "HIMILAN®", an ionomer resin commercialized by Du Pont-Mitsui Polychemicals, Co. , Ltd. , Tokyo, Japan, and injecting a Redox electrolyte, i.e., an acetonitrile solution comprising 45 mM iodide, 30 mM lithium iodide, 330 mM dimethyl imidazolium=iodide, and 0.1 mM 4-tert-butylpyridine to obtain a photoelectric conversion element.

### Example 8

### Photoelectric conversion property of photoelectric converting element

A photoelectric conversion element, obtained by the method in Example 7, was examined for photoelectric conversion property in a usual manner. As a light source, a common solar simulator, prepared by using in combination a xenon lamp and a band pass filter having an air mass (AM) 1.5, an illumination intensity of 94,500 lux, and a radiation energy intensity of 82 mW/cm². In parallel, a photoelectric conversion element was prepared similarly as above except for omitting the organic metal complex represented by Chemical Formula 1, and examined for photoelectric conversion property similarly as above. The results are in Table 1.

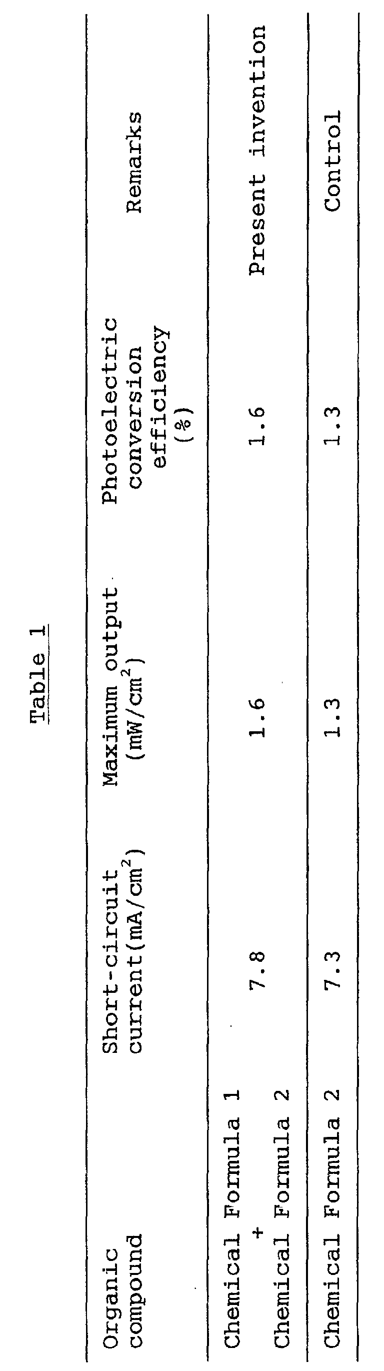

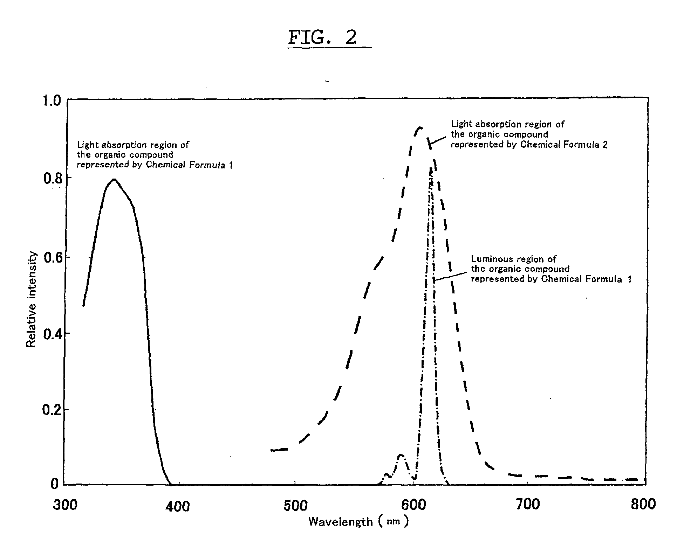

As evident from the results in Table 1, the photoelectric conversion element of the present invention was superior in short-circuit current density and luminous conversion efficiency to the photoelectric conversion element free of installing the organic metal complex, represented by Chemical Formula 1, as a control. The short-circuit current and the photoelectric conversion efficiency of the photoelectric conversion element as a control were respectively 7.3 mA/cm² and 1.3%, while those of the one of the present invention were respectively 7.8 mA/cm² and 1.6%, meaning that the levels of the latter were significantly higher than those of the former. Also the photoelectric conversion element of the present invention had a maximum output of 1.6 mW/cm², i.e., 1.2-fold higher than the level of 1.3 mW/cm² as that of the control. The organic compounds, represented by Chemical Formulae 1 and 2, had the light absorption region and the luminous region as shown in FIG. 2. When irradiated with light having a wavelength of around 346 nm in the ultraviolet region, the organic compound represented by Chemical Formula 1 is excited to emit light having a wavelength of around 613 nm in the orange region. As shown in FIG. 2, since the luminous region of the organic compound represented by Chemical Formula 1 is superposed on the absorption region of the organic compound represented by Chemical Formula 2, the light emitted from the former is substantially absorbed by the latter when they are coexisted. When irradiated with light comprising a light component having awavelength of around 600 nm, the organic compound represented by Chemical Formula 2 instantly absorbs such light. Since each of the absorption peaks and the luminescent peaks in FIG. 2 are mere examples for explaining the energy transfer between the two organic compounds, the level of each peak does not accurately reflect the actual intensities of the absorption and luminescence of the compounds.

These results indicate that a relatively high photoelectric conversion efficiency, that could not be attained by a single use of a light absorptive organic compound, will beattainedinahigherlevelby, according to the present invention, applying together a luminous organic compound and a light absorptive organic compound to a luminous conversion element in order to convert light with a wavelength ranging from the ultraviolet region to the near infrared region, which has not been effectively used in conventional photoelectric conversion elements, into another light, with a longer wavelength than that of the above absorbed light, ranging from the visible region to the infrared region.

### Example 9

### Photoelectric conversion element

A photoelectric conversion element was prepared similarly as in Examples 6 and 7 except for replacing the light absorptive composition obtained by the method in Example 1 with the one obtained by the method in Example 5.

The photoelectric conversion element with an improved photoelectric conversion efficiency is quite useful in photochemical solar cells as a basic element.

### POSSIBILITY OF INDUSTRIAL APPLICABILITY

As described above, the light absorptive composition of the present invention was made based on the finding that the light absorbability of light absorptive organic compounds can be apparently expanded to an extent as if the ability has been expanded up to a wavelength region that is not intrinsically absorbed by light absorptive organic compounds by exciting luminous organic compounds with light having a wavelength ranging from the ultraviolet region to the visible region, and allowing light absorptive compounds to absorb the light emitted from the excited luminous organic compounds. Since the light absorptive composition of the present invention, comprising the above identified luminous organic compound(s) and the light absorptive organic compound(s), can be imparted with a light absorbability in the desired wavelength region ranging from the ultraviolet region to the visible region, it can be quite advantageously used in various fields, for example, photoelectric conversion elements and photochemical polymerizations.

Particularly, the use of the light absorptive composition with an advantageous applicability to semiconductors in solar cells, specifically, to photoelectric conversion elements such as photochemical solar cells, will easily and effectively use even the light ranging from the ultraviolet region to the near ultraviolet region, resulting in a significant improvement of photochemical conversion efficiency in photoelectric conversion elements.

The present invention with such an outstanding function and effect is a significant invention that will greatly contribute to this art.

## Claims

1. A light absorptive composition, comprising a first organic compound which absorbs light with a wavelength ranging from the ultraviolet region to the visible region to emit light with a longer wavelength than that of the absorbed light, and a second organic compound which absorbs the light emitted from the first organic compound.

2. The light absorptive compound of claim 1, which is a photosensitizer.

3. A semiconductor electrode, which has been photosensitized with the light absorptive composition of claim 1 or 2.

4. A photoelectric conversion element, comprising the light absorptive composition of claim 1 or 2.

5. A solar cell, comprising the light absorptive composition of claim 1 or 2.

6. The solar cell of claim 5, which is a photoelectrochemical solar cell.
